(19) Europäisches Patentamt
European Patent Office
Office européen des brevets

(11) EP 4 780 145 A1

(12) **EUROPEAN PATENT APPLICATION**
published in accordance with Art. 153(4) EPC

(43) Date of publication:
**22.07.2026 Bulletin 2026/30**

(21) Application number: **25766861.6**

(22) Date of filing: **24.01.2025**

(51) International Patent Classification (IPC):
***H05K 3/38*** *(2006.01)* ***H05K 3/42*** *(2006.01)*
***H05K 3/00*** *(2006.01)* ***H05K 1/03*** *(2006.01)*
***C03C 17/36*** *(2006.01)* ***C03C 17/00*** *(2006.01)*
***C03C 15/00*** *(2006.01)*

(52) Cooperative Patent Classification (CPC):
**C03C 15/00; C03C 17/00; C03C 17/36; H05K 1/03; H05K 3/00; H05K 3/38; H05K 3/42**

(86) International application number:
**PCT/KR2025/001436**

(87) International publication number:
**WO 2026/049181 (05.03.2026 Gazette 2026/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **02.09.2024 KR 20240118561**
**31.12.2024 KR 20240201651**

(71) Applicant: **LG Chem, Ltd.**
**Seoul 07336 (KR)**

(72) Inventors:
- **CHOI, A Nam**
  **Seoul 07796 (KR)**
- **KWON, Oh Tak**
  **Seoul 07796 (KR)**
- **RYU, Sanguk**
  **Seoul 07796 (KR)**
- **JUNG, Dae Chul**
  **Seoul 07796 (KR)**
- **YOO, Sangmoon**
  **Seoul 07796 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **GLASS SUBSTRATE METALLIZATION PROCESS, GLASS SUBSTRATE MANUFACTURING PROCESS COMPRISING SAME, AND METALLIZED GLASS SUBSTRATE**

(57) The present disclosure is directed to providing a glass substrate metallization process which includes a glass substrate metallization-accelerating process using a specific composition, and thus can form a metal layer uniformly on a glass substrate having a high aspect ratio merely through a wet process.

FIG. 3

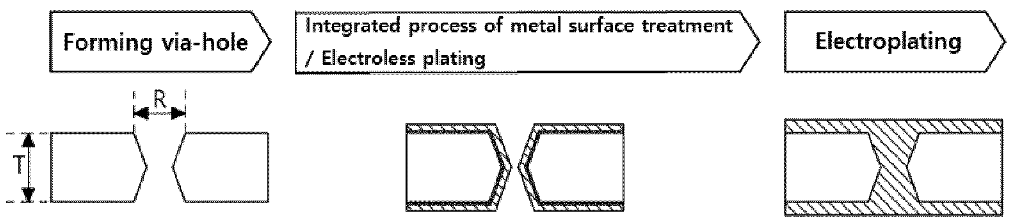


EP 4 780 145 A1

## Description

[Technical Field]

The present disclosure relates to a glass substrate metallization process, a process for manufacturing a glass substrate including the same and a metallized glass substrate.

The present application claims the benefit of Korean Patent Application No. 10-2024-0118561 filed on September 2, 2024 and Korean Patent Application No. 10-2024-0201651 filed on December 31, 2024, in the Korean Intellectual Property Office, the entire disclosure of which is incorporated herein by reference.

[Background Art]

Since glass substrates are excellent in terms of warpage and coefficient of thermal expansion (CTE), they are capable of realizing large-area substrates and are advantageous to high-speed signaling and heat emission through an increase in I/O number.

However, glass substrates are problematic in that they show low adhesion to metals and cannot allow direct electroless plating on glass substrates.

Therefore, there is a need for studies about technologies for improving adhesion between glass and copper, and particularly, technologies capable of ensuring reliability even at high temperature and high humidity are required.

According to the related art, electroless copper plating has been conducted after forming Cu seeds on the surface of a glass substrate through Cu sputtering. However, there is a disadvantage in that when the thickness of a glass substrate is increased or the diameter of a through glass via (TGV) hole is reduced (i.e. when the aspect ratio is increased), Cu seeds are not formed at the central portion inside of the TGV hole.

Therefore, when electroless plating is carried out through the conventional method, there is a difficulty in improving the aspect ratio of a glass substrate.

Under these circumstances, there is a need for developing a metal surface treatment method capable of metal plating on the surface of a glass substrate particularly even at high temperature and high humidity while increasing the aspect ratio of the glass substrate.

[References]

(Patent Document 1) Korean Patent Laid-Open No. 10-2010-0135603

**[Disclosure]**

[Technical Problem]

The present disclosure is directed to providing a glass substrate metallization process, a process for manufacturing a glass substrate including the same and a metallized glass substrate.

[Technical Solution]

An exemplary embodiment of the present disclosure provides a glass substrate metallization process including: a glass substrate metallization-accelerating process; a glass substrate plating process; and an annealing process, wherein the glass substrate metallization-accelerating process includes a step of carrying out surface treatment of a glass substrate by using a glass substrate metallization-accelerating composition, the glass substrate metallization-accelerating composition includes a silane coupling agent and a Pd binder, and the Pd binder is a metal ion-containing compound including a functional group capable of binding with the silane coupling agent.

Another exemplary embodiment of the present disclosure provides a process for manufacturing a glass substrate including the glass substrate metallization process.

Still another exemplary embodiment of the present disclosure provides a metallized glass substrate obtained by the process for manufacturing a glass substrate.

Still another exemplary embodiment of the present disclosure provides a metallized glass substrate including: a glass substrate; and a metal layer provided on the glass substrate, wherein a metallization-accelerating layer is contained between the glass substrate and the metal layer, and the metallization-accelerating layer includes a silane coupling agent, and a Pd binder containing a functional group bound with the silane coupling agent and a metal ion.

Yet another exemplary embodiment of the present disclosure provides a metallized glass substrate including: a glass substrate having a via-hole; and a metal layer provided in the via-hole of the glass substrate, wherein a metallization-accelerating layer is contained between the glass substrate and the metal layer, and the metallization-accelerating layer includes a silane coupling agent, and a Pd binder containing a functional group bound with the silane coupling agent and a metal ion.

[Advantageous Effects]

A glass substrate metallization process according to an exemplary embodiment of the present disclosure includes a glass substrate metallization-accelerating process using a specific composition, and thus can omit Cu seed formation performed through Cu sputtering during the conventional electroless copper plating process of a glass substrate and can accomplish metallization of a glass substrate merely through a wet process.

In addition, a glass substrate metallization process according to an exemplary embodiment of the present disclosure can be expected to increase the aspect ratio of a glass substrate by increasing the thickness of the glass substrate or by reducing the diameter of a TGV hole.

Moreover, it is possible to enhance adhesion between a glass substrate and a metal layer not only at room temperature but also even at high temperature and high humidity, and thus to provide an advantage of an excellent plating coverage ratio by virtue of a uniform metal layer thickness.

[Brief Description of Drawings]

FIG. 1 and FIG. 2 are schematic views illustrating a process for manufacturing a glass substrate and a glass substrate metallization process according to the related art.
FIG. 3 is schematic view illustrating a process for manufacturing a glass substrate and a glass substrate metallization process according to the present disclosure.
FIG. 4 is a schematic view illustrating a glass substrate metallization process according to the present disclosure.
FIG. 5 shows criteria referenced to evaluate the plating uniformity of a glass substrate according to the present disclosure.
FIG. 6 shows the measurement position of each thickness measured to evaluate the plating coverage ratio of a glass substrate according to the present disclosure.

[Description of drawing numerals]

10: Silane coupling agent
20: Pd binder
30: Pd catalyst
T: Thickness of glass substrate
R: Diameter of via-hole of glass substrate
A: Position where Pd binder is bound with Pd catalyst
B: Position where Pd binder is bound with silane coupling agent
T1: Cu thickness of glass substrate surface
T2: Cu thickness at point corresponding to 1/4 of thickness inside glass substrate via-hole
T3: Cu thickness at point corresponding to 2/4 of thickness inside glass substrate via-hole
T4: Cu thickness at point corresponding to 3/4 of thickness inside glass substrate via-hole

[Best Mode]

Hereinafter, the present disclosure will be explained in detail.

Throughout the present specification, when a part is described to "include" a component, this does not exclude the presence of another component but rather implies that further components may be included, unless the context specifically states otherwise.

Throughout the present specification, there is no particular limitation in a glass substrate, as long as it is one used as a substrate made of glass in the art. For example, the glass substrate disclosed herein may be a glass substrate having a via-hole.

Throughout the present specification, "glass substrate metallization" generally refers to plating of a glass substrate, i.e. formation of a metal layer on at least one surface of a glass substrate, and the metal type used for plating

is not limited, but particular examples thereof may include copper (Cu) or nickel (Ni), specifically Cu.

Throughout the present specification, "surface of a glass substrate" or "on a glass substrate" may refer to any part of the glass substrate that is in contact with the outside.

An exemplary embodiment of the present disclosure provides a glass substrate metallization process including: a glass substrate metallization-accelerating process; a glass substrate plating process; and an annealing process.

In an exemplary embodiment of the present disclosure, the glass substrate metallization process is characterized in that the glass substrate metallization-accelerating process includes a step of carrying out surface treatment of a glass substrate by using a glass substrate metallization-accelerating composition, the glass substrate metallization-accelerating composition includes a silane coupling agent and a Pd binder, and the Pd binder is a metal ion-containing compound including a functional group capable of binding with the silane coupling agent.

FIG. 4 is a schematic view illustrating a glass substrate metallization process according to the present disclosure. Specifically, hydroxyl groups (-OH) are formed on the surface of a glass substrate, after the glass substrate is subjected to a pretreatment process. When the glass substrate is treated with the above-mentioned glass substrate metallization-accelerating composition, oxygen of the silane coupling agent 10 in the composition forms hydrogen bonding with the hydroxyl groups of the glass substrate surface, and the chain portions of the silane coupling agent are distributed on the glass substrate while being bound with B of the Pd binder 20. In addition, A of the Pd binder 20 is bound with a Pd catalyst 30, and a metal layer (e.g. Cu layer) is formed on the Pd catalyst 30 through a plating process. Then, Si-O-Si condensation occurs in the subsequent annealing process, and the metal layer is in close contact with the glass substrate.

In an exemplary embodiment of the present disclosure, the glass substrate metallization-accelerating process and glass substrate plating process may be wet processes.

In an exemplary embodiment of the present disclosure, the glass substrate metallization process may be a totally wet process.

**<u>Glass substrate metallization-accelerating process</u>**

In an exemplary embodiment of the present disclosure, the glass substrate metallization-accelerating process includes a step of carrying out surface treatment of a glass substrate by using a glass substrate metallization-accelerating composition.

In an exemplary embodiment of the present disclosure, the glass substrate metallization-accelerating composition includes a silane coupling agent and a Pd binder, and the Pd binder is a metal ion-containing compound including a functional group capable of binding with the silane coupling agent.

In an exemplary embodiment of the present disclosure, the glass substrate metallization-accelerating process may include the steps of: allowing a hydroxyl group formed on the surface of the glass substrate by a glass substrate pretreatment process to be bound with the silane coupling agent; and allowing the silane coupling agent to be bound with the Pd binder.

In an exemplary embodiment of the present disclosure, treatment with the glass substrate metallization-accelerating composition may be carried out by using a spraying or dipping method.

In an exemplary embodiment of the present disclosure, the glass substrate metallization-accelerating process may be carried out at a temperature of 10-50°C.

In an exemplary embodiment of the present disclosure, the glass substrate metallization-accelerating process may further include a step of applying a Pd catalyst.

In an exemplary embodiment of the present disclosure, the glass substrate metallization-accelerating process may include: a process for preparing binding of a glass substrate with a Pd catalyst; and a process for binding the glass substrate with the Pd catalyst.

In an exemplary embodiment of the present disclosure, the glass substrate metallization-accelerating composition may be used in the process for preparing binding of a glass substrate with a Pd catalyst.

In an exemplary embodiment of the present disclosure, the step of carrying out surface treatment of a glass substrate by using a glass substrate metallization-accelerating composition may be the process for preparing binding of a glass substrate with a Pd catalyst.

In an exemplary embodiment of the present disclosure, the process for preparing binding of a glass substrate with a Pd catalyst may be carried out at a temperature of 15-30°C for 2-10 minutes.

In an exemplary embodiment of the present disclosure, the process for preparing binding of a glass substrate with a Pd catalyst may be a process for treating a glass substrate having a hydroxyl group formed on the surface thereof with the above-mentioned glass substrate metallization-accelerating composition to obtain a glass substrate including a Pd binder bound to and distributed on the surface of the glass substrate.

In an exemplary embodiment of the present disclosure, the process for binding the glass substrate with the Pd catalyst may be a process for applying the Pd catalyst onto the glass substrate including the Pd binder bound to the surface thereof.

In an exemplary embodiment of the present disclosure, the Pd catalyst may be applied by using a dipping method.

In an exemplary embodiment of the present disclosure, the process for binding the glass substrate with the Pd catalyst may be carried out at a temperature of 30-50°C for 2-10 minutes.

In an exemplary embodiment of the present disclosure, the Pd catalyst may be a catalyst containing $Pd^{2+}$ and a ligand, but there is no particular limitation as long as the Pd catalyst is one used in the art.

In an exemplary embodiment of the present disclosure, the Pd catalyst may include a structure represented by $[Pd\text{-}X]^{2+}$, wherein X may include 2-vinylpyridine or 2-methylpyridine.

In an exemplary embodiment of the present disclosure, the Pd catalyst may include a structure represented by the following structural formula:

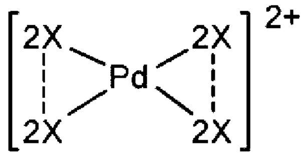

When treating the glass substrate including the Pd binder bound to the surface thereof with the Pd catalyst, the Pd binder may be bound with $Pd^{2+}$ ions released from the Pd catalyst or may be bound directly with the Pd catalyst.

In an exemplary embodiment of the present disclosure, the glass substrate metallization-accelerating process may further include a Pd catalyst reduction process.

Specifically, the Pd catalyst reduction process may be a process for reducing $Pd^{2+}$ ions of the Pd catalyst into Pd metal.

In an exemplary embodiment of the present disclosure, any Pd catalyst reduction process may be used, as long as it is known to those skilled in the art.

In an exemplary embodiment of the present disclosure, the Pd catalyst reduction process may be carried out at a temperature of 20-40°C for 1-10 minutes.

In an exemplary embodiment of the present disclosure, the glass substrate metallization-accelerating composition is characterized in that it includes a silane coupling and a Pd binder, wherein the Pd binder is a metal ion-containing compound including a functional group capable of binding with the silane coupling agent.

Specifically, when the glass substrate is surface-treated by using the glass substrate metallization-accelerating composition, the glass substrate may be bound with the silane coupling agent, the silane coupling agent may be bound with the Pd binder through the functional group of the Pd binder capable of binding with the silane coupling agent, and the Pd binder may be bound with the Pd catalyst through the characteristic of the Pd binder as a metal ion-containing compound.

In addition, it is possible to omit a step of forming Cu seeds through Cu sputtering when plating is carried out on the glass substrate, by using the glass substrate metallization-accelerating composition. Since the step of forming Cu seeds through Cu sputtering is carried out through a dry process, and then the subsequent plating process is carried out through a wet process, the dry process and the wet process are carried out separately. On the other hand, when using the glass substrate metallization-accelerating composition, the glass substrate may be metallized merely through a wet process.

FIG. 1 and FIG. 2 show a process for manufacturing a glass substrate according to the related art. Specifically, FIG. 1 shows a process using a sputtering method, wherein electroless plating is carried out through Cu seed formation and then electroplating is carried out, when a via-hole is formed in the glass substrate and the glass substrate having the via-hole is subjected to plating treatment. However, in such a process, there is a problem in that Cu cannot be deposited well at the central portion inside of the hole, when the aspect ratio is increased by increasing the thickness of the glass substrate or by reducing the diameter of the hole. FIG. 2 shows a liquid deposition method which is a method for increasing adhesion of the glass substrate with metal by using a metal oxide. In this case, the method requires a longer tact time, provides lower adhesion and causes formation of a non-uniform thin film, as compared to the process for manufacturing a glass substrate according to the present disclosure.

On the contrary, FIG. 3 shows a process for manufacturing a glass substrate according to the present disclosure, wherein an integrated process of metal surface treatment/electroless plating, i.e. metallization process according to the present disclosure is carried out totally through a wet process, and sufficient Cu deposition is accomplished and a plating layer having a uniform thickness can be formed even at a high aspect ratio. In addition, the process according to the present disclosure requires a shorter tack time as compared to the conventional processes, and thus can provide improved productivity.

Particularly, since the composition used in the metallization-accelerating process of the metallization process according to the present disclosure includes the silane coupling agent and Pd binder, -OH group formed on the glass substrate that has been subjected to a pretreatment process forms hydrogen bonding with one end of the silane coupling

agent, the other end of the silane coupling agent is bound with the Pd binder, and the Pd catalyst is bound to the Pd binder. In this manner, while the Pd catalyst is formed on the substrate, Cu plating is allowed through excellent binding force between Pd and Cu.

Hereinafter, the composition will be explained in detail in terms of its constitution.

First, substituents related with the following chemical formulae will be defined as follows.

In the present disclosure, an alkyl group may be a straight or branched chain, and the number of carbon atoms is not particularly limited, but may be 1-30 preferably. Particular examples of the alkyl group include methyl, ethyl, propyl, butyl, pentyl, hexyl, heptyl, etc., but are not limited thereto.

In the present disclosure, the above exemplification of the alkyl group is applied to an alkylene group, except that the alkylene group is divalent.

In the present disclosure, a condensed heterocylic group refers to a monovalent ring having a heterocyclic ring condensed with an aliphatic hydrocarbon ring or aromatic hydrocarbon ring.

In the present disclosure, a heterocycle includes one or more atom other than carbon, i.e. one or more heteroatom, and specifically, may include one or more atom selected from the group consisting of O, N, Se and S. There is no particular limitation in the number of carbon atoms, but the number of carbon atoms may be 2-30 preferably, and the heterocycle may be a monocycle or multicycle.

In the present disclosure, an aliphatic hydrocarbon ring is not particularly limited, but preferably has 3-30 carbon atoms, and particular examples thereof include cyclopropane, cyclobutane, cyclopentane, cyclohexane, bi(cyclohexane), cycloheptane, cyclooctane, etc., but are not limited thereto.

In the present disclosure, an aromatic hydrocarbon ring is not particularly limited, but preferably has 6-30 carbon atoms, and particular examples thereof include benzene (phenyl), biphenyl, terphenyl, naphthalene, anthracene, phenanthrene, pyrene, fluorene, etc., but are not limited thereto.

**<Silane coupling agent>**

In an exemplary embodiment of the present disclosure, the glass substrate metallization-accelerating composition may include at least one silane coupling agent.

In an exemplary embodiment of the present disclosure, the glass substrate metallization-accelerating composition may include two or more silane coupling agents.

In an exemplary embodiment of the present disclosure, the glass substrate metallization-accelerating composition may include one silane coupling agent or two silane coupling agents.

In an exemplary embodiment of the present disclosure, the silane coupling agent may be represented by the following Chemical Formula 2:

[Chemical Formula 2]

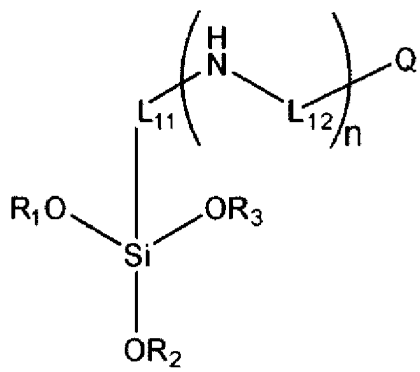

In Chemical Formula 2,

$R_1$ to $R_3$ are the same or different, and are each independently a C1-C5 alkyl group,
$L_{11}$ and $L_{12}$ are the same or different, and are each independently a C1-C5 alkylene group,
n is 0 or 1, and
Q is -SH, $-NH_2$ or a condensed heterocyclic group containing O.

In an exemplary embodiment of the present disclosure, at least one of $R_1$ to $R_3$ in the above Chemical Formula 2 may form hydrogen bonding with -OH on the surface of the glass substrate.

In an exemplary embodiment of the present disclosure, Q in Chemical Formula 2 may be bound with the Pd binder.

In an exemplary embodiment of the present disclosure, $R_1$ to $R_3$ are the same or different, and are each may independently a methyl, ethyl, propyl, butyl or pentyl group.

In an exemplary embodiment of the present disclosure, $R_1$ to $R_3$ are the same or different, and are each may independently a methyl or ethyl group.

In an exemplary embodiment of the present disclosure, $L_{11}$ and $L_{12}$ are the same or different, and are each may independently a methylene, ethylene, propylene, butylene or pentylene group.

In an exemplary embodiment of the present disclosure, $L_{11}$ and $L_{12}$ are the same or different, and are each may independently a C2-C4 alkylene group.

In an exemplary embodiment of the present disclosure, $L_{11}$ and $L_{12}$ are the same or different, and are each may independently an ethylene, propylene or butylene group.

In an exemplary embodiment of the present disclosure, Q may be -SH, $-NH_2$ or a C2-C60 condensed heterocyclic group containing O.

In an exemplary embodiment of the present disclosure, Q may be -SH, $-NH_2$ or a condensed cyclic group of oxirane ring with cyclohexane ring.

In an exemplary embodiment of the present disclosure, Q may be -SH or a condensed cyclic group of oxirane ring with cyclohexane ring.

With reference to the silane coupling agent according to the present disclosure, when an aminosilane coupling agent in which Q of Chemical Formula 2 is $-NH_2$ is used alone, it may form hydrogen bonding with -OH group of the glass substrate to cause degradation of binding force of the silane coupling agent with the Pd binder, resulting in degradation of adhesion under the condition of highly accelerated stress test (HAST). Therefore, Q is preferably -SH or a C2-C60 condensed heterocyclic group containing O.

In an exemplary embodiment of the present disclosure, n may be 0.

In an exemplary embodiment of the present disclosure, n may be 1.

In an exemplary embodiment of the present disclosure, the silane coupling agent may be represented by the following Chemical Formula 2-1 or 2-2:

[Chemical Formula 2-1]

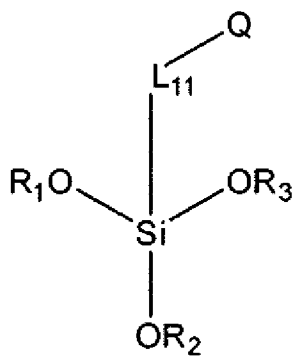

[Chemical Formula 2-2]

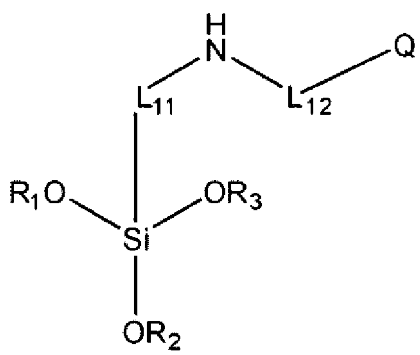

In Chemical Formula 2-1 and Chemical Formula 2-2,

$R_1$ to $R_3$ are the same or different, and are each independently a C1-C5 alkyl group,
$L_{11}$ and $L_{12}$ are the same or different, and are each independently a C1-C5 alkylene group, and
Q is -SH, $-NH_2$ or a condensed heterocyclic group containing O.

In an exemplary embodiment of the present disclosure, the silane coupling agent may be represented by the above Chemical Formula 2-1.

In an exemplary embodiment of the present disclosure, the glass substrate metallization-accelerating composition may include one silane coupling agent or two silane coupling agents represented by the above Chemical Formula 2.

**<Pd binder>**

In an exemplary embodiment of the present disclosure, the glass substrate metallization-accelerating composition may include one or more Pd binder.

In an exemplary embodiment of the present disclosure, the glass substrate metallization-accelerating composition may include two or more Pd binders.

In an exemplary embodiment of the present disclosure, the glass substrate metallization-accelerating composition may include one Pd binder or two Pd binders.

In an exemplary embodiment of the present disclosure, the Pd binder may be a metal ion-containing compound.

In an exemplary embodiment of the present disclosure, the Pd binder may be a lithium ion-containing compound.

In an exemplary embodiment of the present disclosure, the Pd binder includes a functional group capable of binding with the silane coupling agent.

In an exemplary embodiment of the present disclosure, the Pd binder may include a carboxyl group as the functional group capable of binding with the silane coupling agent.

In an exemplary embodiment of the present disclosure, the Pd binder may be represented by the following Chemical Formula 1:

[Chemical Formula 1]

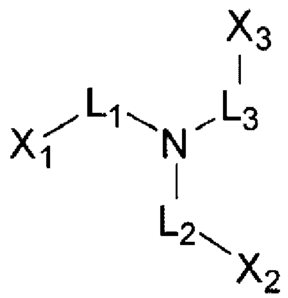

In Chemical Formula 1,

$L_1$ to $L_3$ are the same or different, and are each independently a C1-C5 alkylene group,
$X_1$ is $-NH_2$, -OH, -C(=O)OH or $-P(=O)(OH)_2$,
$X_2$ and $X_3$ are the same or different, and are each independently $-NH_2$, -OH, -C (=O) OH, -C (=O) $O^-M^+$, $-P(=O)(OH)_2$, -P(=O)(OH) ($O^-M^+$) or $-P(=O)(O^-M^+)_2$,
M is Li or Na, and
at least one of $X_2$ and $X_3$ is -C (=O) $O^-M^+$, -P(=O)(OH) ($O^-M^+$) or $-P(=O)(O^-M^+)_2$.

The Pd binder according to the present disclosure is characterized in that it contains an amino, hydroxyl, carboxyl or phosphonate group in its tertiary amine structure, and includes at least one metal ion.

In an exemplary embodiment of the present disclosure, the functional group of the Pd binder capable of binding with the silane coupling agent may be $X_1$ of the above Chemical Formula 1.

Since the Pd binder represented by Chemical Formula 1 includes -C (=O)$O^-M^+$, -P(=O)(OH) ($O^-M^+$) or $-P(=O)(O^-M^+)_2$, it has high ionic property and can be dissociated with ease in the composition and the corresponding site may selectively react with the Pd catalyst. In other words, the Pd binder represented by Chemical Formula 1 shows excellent binding force with the Pd catalyst and can form a uniform metal layer during a plating process.

In addition, when a heteroatom (S, N, etc.) is contained in the linker ($L_1$ to $L_3$) of the Pd binder represented by Chemical Formula 1, there is a difficulty in controlling the binding site with the Pd binder. In addition, since the Pd binder represented by Chemical Formula 1 includes a hydrocarbon linker ($L_1$ to $L_3$) having an adequate length, it is possible to

form a stable three-dimensional structure.

In an exemplary embodiment of the present disclosure, $L_1$ to $L_3$ are the same or different, and are each may independently a methylene, ethylene, propylene, butylene or pentylene group.

In an exemplary embodiment of the present disclosure, $L_1$ to $L_3$ are the same or different, and are each may independently a C1-C3 alkylene group.

In an exemplary embodiment of the present disclosure, $L_1$ to $L_3$ are the same or different, and are each may independently a methylene, ethylene or propylene group.

In an exemplary embodiment of the present disclosure, when the alkylene group of $L_1$ to $L_3$ has an increased length, there is a problem in that it is difficult to perform reaction in an aqueous solution phase.

In an exemplary embodiment of the present disclosure, $X_1$ may be $-C(=O)OH$ or $-P(=O)(OH)_2$.

In an exemplary embodiment of the present disclosure, $X_1$ may be $-C(=O)OH$.

In an exemplary embodiment of the present disclosure, $X_1$ may be $-P(=O)(OH)_2$.

In an exemplary embodiment of the present disclosure, $X_2$ and $X_3$ are the same or different, and are each may independently $-C(=O)OH$, $-C(=O)O^-Li^+$, $-P(=O)(OH)_2$, $-P(=O)(OH)(O^-Li^+)$ or $-P(=O)(O^-Li^+)_2$, and at least one of $X_2$ and $X_3$ may be $-C(=O)O^-Li^+$, $-P(=O)(OH)(O^-Li^+)$ or $-P(=O)(O^-Li^+)_2$.

In an exemplary embodiment of the present disclosure, $X_2$ and $X_3$ may be $-C(=O)O^-Li^+$, $-P(=O)(OH)(O^-Li^+)$ or $-P(=O)(O^-Li^+)_2$.

In an exemplary embodiment of the present disclosure, M may be Li or Na.

In an exemplary embodiment of the present disclosure, M is preferably Li, and in this case, it is possible to provide higher binding force with Pd as compared to the case in which M is Na.

In an exemplary embodiment of the present disclosure, when M is K or Cu, it shows lower ionic property as compared to Li, and thus Pd binding strength is poor, it is difficult to form a uniform plating layer.

In an exemplary embodiment of the present disclosure, the Pd binder may be represented by the following Chemical Formula 1-1 or 1-2:

[Chemical Formula 1-1]

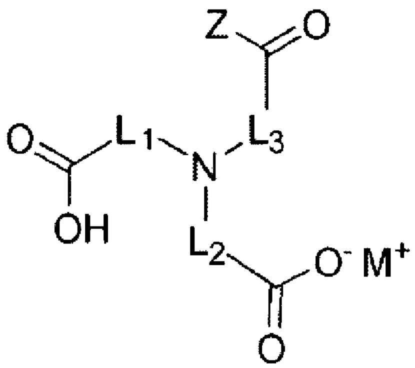

[Chemical Formula 1-2]

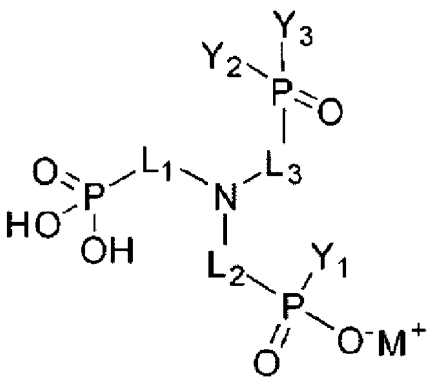

In Chemical Formula 1-1 and Chemical Formula 1-2,

$L_1$ to $L_3$ are the same or different, and are each independently a C1-C5 alkylene group,
Z is $-OH$ or $-O^-M^+$,

$Y_1$ to $Y_3$ are the same or different, and are each independently -OH or $-O^-M^+$, and
M is Li or Na.

In an exemplary embodiment of the present disclosure, the glass substrate metallization-accelerating composition may include one Pd binder or two Pd binders represented by the above Chemical Formula 1.
In an exemplary embodiment of the present disclosure, the glass substrate metallization-accelerating composition may include one Pd binder represented by the above Chemical Formula 1.
In an exemplary embodiment of the present disclosure, the glass substrate metallization-accelerating composition may further include an additional Pd binder other than the Pd binder represented by the above Chemical Formula 1.
In an exemplary embodiment of the present disclosure, the additional Pd binder may include no metal ion.
In an exemplary embodiment of the present disclosure, the additional Pd binder may not be a metal ion-containing compound.
In an exemplary embodiment of the present disclosure, the additional Pd binder may be represented by the following Chemical Formula 3:

[Chemical Formula 3]

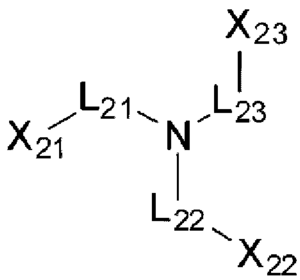

In Chemical Formula 3,

$L_{21}$ to $L_{23}$ are the same or different, and are each independently a C1-C5 alkylene group, and
$X_{21}$ to $X_{23}$ are the same or different, and are each independently -C(=O)OH or $-P(=O)(OH)_2$.

**<Phase stabilizer>**

In an exemplary embodiment of the present disclosure, the glass substrate metallization-accelerating composition may further include a phase stabilizer selected from hydrochloric acid, sulfuric acid, methanol, ethanol, isopropyl alcohol and sodium hydroxide.
In an exemplary embodiment of the present disclosure, the glass substrate metallization-accelerating composition may include one or more phase stabilizer.
In an exemplary embodiment of the present disclosure, the glass substrate metallization-accelerating composition may include two or more phase stabilizers.
In an exemplary embodiment of the present disclosure, the glass substrate metallization-accelerating composition may include one phase stabilizer or two phase stabilizers.
In an exemplary embodiment of the present disclosure, when using the phase stabilizer, it is possible to control pH of the composition to a range of 0.5-5 or 9-12 so that hydrogen bonding of -OH group of the glass substrate with the silane coupling agent may be performed smoothly.
The phase stabilizer functions to control pH to a desired range and to improve the stability of the silane coupling agent. Specifically, it is possible to control pH by using a phase stabilizer, such as hydrochloric acid, sulfuric acid or sodium hydroxide, and to increase the stability of the silane coupling agent by using a phase stabilize, such as methanol, ethanol or isopropyl alcohol.
In an exemplary embodiment of the present disclosure, the phase stabilizer may include one selected from hydrochloric acid, sulfuric acid and sodium hydroxide, and one selected from methanol, ethanol and isopropyl alcohol.
In an exemplary embodiment of the present disclosure, the phase stabilizer may include hydrochloric acid and isopropyl alcohol.

**<Solvent>**

In an exemplary embodiment of the present disclosure, the glass substrate metallization-accelerating composition may further include a solvent.

In an exemplary embodiment of the present disclosure, the solvent may be water.

In an exemplary embodiment of the present disclosure, the glass substrate metallization-accelerating composition further includes a solvent, and may include 0.1-5 parts by weight of the silane coupling agent and 0.5-5 parts by weight of the Pd binder, based on 100 parts by weight of the total weight of the glass substrate metallization-accelerating composition, the balance being the solvent.

In an exemplary embodiment of the present disclosure, the glass substrate metallization-accelerating composition further includes a solvent, and may include 0.2-3 parts by weight of the silane coupling agent and 0.5-3 parts by weight of the Pd binder, based on 100 parts by weight of the total weight of the glass substrate metallization-accelerating composition, the balance being the solvent.

In an exemplary embodiment of the present disclosure, the glass substrate metallization-accelerating composition further includes a solvent, and may include 0.3-2 parts by weight of the silane coupling agent and 0.7-3 parts by weight of the Pd binder, based on 100 parts by weight of the total weight of the glass substrate metallization-accelerating composition, the balance being the solvent.

In an exemplary embodiment of the present disclosure, the glass substrate metallization-accelerating composition further includes a solvent, and may include 0.5-2 parts by weight of the silane coupling agent and 1-3 parts by weight of the Pd binder, based on 100 parts by weight of the total weight of the glass substrate metallization-accelerating composition, the balance being the solvent.

In an exemplary embodiment of the present disclosure, the glass substrate metallization-accelerating composition may further include a solvent and a phase stabilizer, and may include 0.1-5 parts by weight of the silane coupling agent, 0.5-5 parts by weight of the Pd binder and 0.1-20 parts by weight of the phase stabilizer, based on 100 parts by weight of the total weight of the glass substrate metallization-accelerating composition, the balance being the solvent.

In an exemplary embodiment of the present disclosure, the glass substrate metallization-accelerating composition may further include a solvent and a phase stabilizer, and may include 0.2-3 parts by weight of the silane coupling agent, 0.5-3 parts by weight of the Pd binder and 0.1-15 parts by weight of the phase stabilizer, based on 100 parts by weight of the total weight of the glass substrate metallization-accelerating composition, the balance being the solvent.

In an exemplary embodiment of the present disclosure, the glass substrate metallization-accelerating composition may further include a solvent and a phase stabilizer, and may include 0.3-2 parts by weight of the silane coupling agent, 0.7-3 parts by weight of the Pd binder and 0.1-10 parts by weight of the phase stabilizer, based on 100 parts by weight of the total weight of the glass substrate metallization-accelerating composition, the balance being the solvent.

In an exemplary embodiment of the present disclosure, the glass substrate metallization-accelerating composition may further include a solvent and a phase stabilizer, and may include 0.5-2 parts by weight of the silane coupling agent, 1-3 parts by weight of the Pd binder and 0.1-8 parts by weight of the phase stabilizer, based on 100 parts by weight of the total weight of the glass substrate metallization-accelerating composition, the balance being the solvent.

In an exemplary embodiment of the present disclosure, the glass substrate metallization-accelerating composition may further include a solvent, a phase stabilizer and an additional Pd binder, and may include 0.1-5 parts by weight of the silane coupling agent, 0.5-5 parts by weight of the Pd binder, 0.1-20 parts by weight of the phase stabilizer and 0.1-5 parts by weight of the additional Pd binder, based on 100 parts by weight of the total weight of the glass substrate metallization-accelerating composition, the balance being the solvent.

In an exemplary embodiment of the present disclosure, the glass substrate metallization-accelerating composition may further include a solvent, a phase stabilizer and an additional Pd binder, and may include 0.2-3 parts by weight of the silane coupling agent, 0.5-3 parts by weight of the Pd binder, 0.1-15 parts by weight of the phase stabilizer and 0.1-4 parts by weight of the additional Pd binder, based on 100 parts by weight of the total weight of the glass substrate metallization-accelerating composition, the balance being the solvent.

In an exemplary embodiment of the present disclosure, the glass substrate metallization-accelerating composition may further include a solvent, a phase stabilizer and an additional Pd binder, and may include 0.3-2 parts by weight of the silane coupling agent, 0.7-3 parts by weight of the Pd binder, 0.1-10 parts by weight of the phase stabilizer and 0.3-3 parts by weight of the additional Pd binder, based on 100 parts by weight of the total weight of the glass substrate metallization-accelerating composition, the balance being the solvent.

Another exemplary embodiment of the present disclosure provides a method for preparing a glass substrate metallization-accelerating composition, including the steps of: preparing a mixture by mixing a silane coupling agent with a Pd binder; and agitating the mixture, characterized in that the Pd binder includes a functional group capable of binding with the silane coupling agent and is a metal ion-containing compound.

In an exemplary embodiment of the present disclosure, the mixture may further include a solvent and a phase stabilizer.

The method for preparing a glass substrate metallization-accelerating composition according to an exemplary embodiment of the present disclosure may include the steps of: preparing a mixture by mixing a solvent, at least one silane coupling agent, at least one Pd binder and at least one phase stabilizer; and agitating the mixture.

Detailed description of each of the solvent, silane coupling agent, Pd binder and the phase stabilizer is the same

as described above with reference to the glass substrate metallization-accelerating composition.

In an exemplary embodiment of the present disclosure, the step of agitating the mixture is carried out at a temperature of 15-25°C.

In an exemplary embodiment of the present disclosure, the step of agitating the mixture is carried out for 1-3 hours.

In an exemplary embodiment of the present disclosure, the solvent, silane coupling agent, Pd binder and the phase stabilizer may be mixed in any order.

In an exemplary embodiment of the present disclosure, the step of preparing a mixture may be a step of mixing at least one silane coupling agent, at least one Pd binder and at least one phase stabilizer with the solvent.

In an exemplary embodiment of the present disclosure, the step of preparing a mixture may include the steps of: mixing at least one phase stabilizer with the solvent to prepare a first mixture; mixing at least one Pd binder with the first mixture to prepare a second mixture; and mixing at least one silane coupling agent with the second mixture to prepare a third mixture.

When preparing a mixture in the above-mentioned order, higher stability is realized.

## Glass substrate plating process

In an exemplary embodiment of the present disclosure, the glass substrate plating process may be a process for forming a metal layer on the glass substrate.

In an exemplary embodiment of the present disclosure, the metal layer may be a Cu layer, for example.

In an exemplary embodiment of the present disclosure, the glass substrate plating process may be an electroless plating process.

In an exemplary embodiment of the present disclosure, any glass substrate plating process may be used, as long as it is known to those skilled in the art.

In an exemplary embodiment of the present disclosure, the glass substrate plating process may be carried out at a temperature of 30-50°C.

In an exemplary embodiment of the present disclosure, an electroplating process may be carried out after the glass substrate plating process.

## Annealing process

In an exemplary embodiment of the present disclosure, the annealing process may be an Si-O-Si condensation process.

In the annealing process, Si-O-Si condensation occurs so that the metal layer may be in close contact with the glass substrate.

In general, an annealing process is carried out at a high temperature (about 150°C), high adhesion strength is required between the glass substrate and the metal layer even under a high temperature condition.

In an exemplary embodiment of the present disclosure, any annealing process may be used, as long as it is known to those skilled in the art.

In an exemplary embodiment of the present disclosure, the annealing process may be carried out at a temperature of 100-500°C.

In an exemplary embodiment of the present disclosure, the annealing process may be carried out at a temperature of 200-400°C.

In an exemplary embodiment of the present disclosure, the annealing process may be carried out for 1-2 hours.

## Glass substrate pretreatment process

In an exemplary embodiment of the present disclosure, the glass substrate metallization process may further include a glass substrate pretreatment process.

In an exemplary embodiment of the present disclosure, the glass substrate metallization process may include: a glass substrate pretreatment process; glass substrate metallization-accelerating process; glass substrate plating process; and an annealing process. In other words, the glass substrate pretreatment process may be carried out before the glass substrate metallization-accelerating process.

In an exemplary embodiment of the present disclosure, the glass substrate pretreatment process may include a step of forming a hydroxyl group on the surface of the glass substrate.

In an exemplary embodiment of the present disclosure, the glass substrate pretreatment process may include pretreatment process A of washing the glass substrate by using pretreatment composition A, and pretreatment process B of forming a hydroxyl group on the surface of the glass substrate by using pretreatment composition B.

In an exemplary embodiment of the present disclosure, the pretreatment process A and pretreatment process B may include a process for applying the pretreatment composition A and pretreatment composition B onto the glass substrate, respectively. Specifically, the pretreatment composition A and pretreatment composition B may be applied onto the glass substrate through a spraying or dipping method.

In an exemplary embodiment of the present disclosure, the pretreatment process A may be carried out at a temperature of 40-60°C for 2-10 minutes.

In an exemplary embodiment of the present disclosure, the pretreatment process B may be carried out at a temperature of 15-30°C for 1-5 minutes.

In an exemplary embodiment of the present disclosure, the pretreatment composition A may include: an amine compound; polar solvent; non-polar solvent; and a pretreatment solvent.

In an exemplary embodiment of the present disclosure, the amine compound may include at least one selected from monoisopropanolamine and monoethanolamine.

In an exemplary embodiment of the present disclosure, the polar solvent may include at least one selected from diethyl formamide and N-methylpyrrolidone.

In an exemplary embodiment of the present disclosure, the nonpolar solvent may include at least one selected from butyl diglycol and ethyl diglycol.

In an exemplary embodiment of the present disclosure, the pretreatment solvent may be water.

In an exemplary embodiment of the present disclosure, the pretreatment composition A may include 3-20 wt% of the amine compound, 5-30 wt% of the polar solvent, 10-40 wt% of the nonpolar solvent and 30-80 wt% of the pretreatment solvent, based on 100 parts by weight of the pretreatment composition A.

In an exemplary embodiment of the present disclosure, the pretreatment composition B may include: an acidic solution; and a pretreatment solvent.

In an exemplary embodiment of the present disclosure, the acidic solution may include at least one selected from hydrochloric acid and sulfuric acid.

In an exemplary embodiment of the present disclosure, the pretreatment solvent may be water.

In an exemplary embodiment of the present disclosure, the pretreatment composition B may further include an oxidizing agent.

In an exemplary embodiment of the present disclosure, the oxidizing agent may be hydrogen peroxide.

In an exemplary embodiment of the present disclosure, the pretreatment composition B may include 3-10 wt% of the acidic solution, 0-20 wt% of the oxidizing agent and 80-97 wt% of the pretreatment solvent, based on 100 parts by weight of the pretreatment composition B.

In an exemplary embodiment of the present disclosure, each of the glass substrate pretreatment process, glass substrate metallization-accelerating process and the glass substrate plating process may be carried out within 2-30 minutes.

In an exemplary embodiment of the present disclosure, the glass substrate may have a thickness of 0.3-1.2 mm.

In an exemplary embodiment of the present disclosure, the glass substrate may have a thickness of 0.6-1.2 mm.

In an exemplary embodiment of the present disclosure, the glass substrate may have a thickness of 0.8-1.2 mm.

In an exemplary embodiment of the present disclosure, the glass substrate may include a via-hole.

In an exemplary embodiment of the present disclosure, the via-hole may have a different shape depending on the process for forming a via-hole and is not particularly limited. For example, the via-hole may have a cylindrical shape or hourglass-like shape.

In an exemplary embodiment of the present disclosure, the glass substrate may be a through glass via (TGV) substrate.

In an exemplary embodiment of the present disclosure, the via-hole of the glass substrate may have a diameter of 10-140 μm.

In an exemplary embodiment of the present disclosure, the diameter of the via-hole of the glass substrate refers to the diameter of the via-hole that can be determined outside of the glass substrate. In other words, the diameter of the via-hole may be the diameter of the hole on the top surface of the glass substrate. Specifically, when the via-hole has an hourglass-like shape as shown in FIG. 3, the hole may have an irregular diameter, and in this case, the diameter of the via-hole may be the diameter of the hole that is in a straight line with the top surface of the glass substrate on the basis of the via-hole depth direction (direction perpendicular to the top surface of the glass substrate).

In an exemplary embodiment of the present disclosure, the glass substrate may have an aspect ratio of 1:3 to 1:20.

In the present disclosure, the aspect ratio of the glass substrate may be the ratio of the diameter of a via-hole (via) to the depth thereof. In other words, the aspect ratio of the glass substrate may be the ratio of the diameter of the via-hole to the thickness of the glass substrate.

In the present disclosure, the aspect ratio of the glass substrate may be the aspect ratio of the via-hole of the glass substrate, specifically the ratio of the diameter of the via-hole of the glass substrate : thickness of the glass substrate.

In FIG. 3, the diameter of the via-hole of the glass substrate is R, the thickness of the glass substrate is T, and the aspect ratio of the glass substrate may be R : T.

In an exemplary embodiment of the present disclosure, the glass substrate may have an aspect ratio of 1:5 or more.

In an exemplary embodiment of the present disclosure, the glass substrate may have an aspect ratio of 1:5 to 1:20.

In an exemplary embodiment of the present disclosure, the glass substrate may have an aspect ratio of 1:6 or more.

In an exemplary embodiment of the present disclosure, the glass substrate may have an aspect ratio of 1:6 to 1:20.

When plating of a glass substrate is carried out by using the glass substrate metallization process according to an exemplary embodiment of the present disclosure, it is possible to increase the aspect ratio of the glass substrate.

## Process for manufacturing glass substrate

Still another exemplary embodiment of the present disclosure provides a process for manufacturing a glass substrate, including the glass substrate metallization process.

In an exemplary embodiment of the present disclosure, the process for manufacturing a glass substrate may further include a process for forming a via-hole in the glass substrate.

In an exemplary embodiment of the present disclosure, the process for forming a via-hole in the glass substrate may include: a glass substrate laser modification process; and a glass substrate hole etching process.

In an exemplary embodiment of the present disclosure, the process for manufacturing a glass substrate may be carried out in order of: the glass substrate laser modification process; glass substrate hole etching process; and the glass substrate metallization process.

In an exemplary embodiment of the present disclosure, the glass substrate laser modification process is a process for causing deformation in a glass substrate by using laser modification, and any method known to those skilled in the art may be used for the process.

In an exemplary embodiment of the present disclosure, the glass substrate hole etching process is a process for forming a via-hole at a site where deformation occurs in the glass substrate, and any method known to those skilled in the art may be used for the process.

## Metallized glass substrate

Still another exemplary embodiment of the present disclosure provides a metallized glass substrate obtained by the above-described process for manufacturing a glass substrate.

Still another exemplary embodiment of the present disclosure provides a metallized glass substrate, including: a glass substrate; and a metal layer provided on the glass substrate, wherein a metallization-accelerating layer is contained between the glass substrate and the metal layer, and the metallization-accelerating layer includes a silane coupling agent, and a Pd binder containing a functional group bound with the silane coupling agent and a metal ion.

Yet another exemplary embodiment of the present disclosure provides a metallized glass substrate including: a glass substrate having a via-hole; and a metal layer provided in the via-hole of the glass substrate, wherein a metallization-accelerating layer is contained between the glass substrate and the metal layer, and the metallization-accelerating layer includes a silane coupling agent, and a Pd binder containing a functional group bound with the silane coupling agent and a metal ion.

In the present disclosure, the metallized glass substrate refers to a structure having a metal layer formed on at least one surface of a glass substrate.

The metallized glass substrate according to the present disclosure is characterized in that the glass substrate is metallized by using the glass substrate metallization-accelerating composition, not a Cu sputtering process. In general, when using a Cu sputtering process, Cu seeds are formed through Ti-Cu sputtering, and the metallized glass substrate may include Ti. On the other hand, the metallized glass substrate according to the present disclosure does not use a Ti-Cu sputtering process, and thus the metallized glass substrate includes no Ti.

The metallized glass substrate according to the present disclosure may show an adhesion strength of 4B or more, as evaluated at room temperature.

The metallized glass substrate according to the present disclosure may show an adhesion strength of 5B or more, as evaluated at room temperature.

The metallized glass substrate according to the present disclosure may show an adhesion strength of 4B or more, as evaluated under the condition of highly accelerated stress test (HAST).

The metallized glass substrate according to the present disclosure may show an adhesion strength of 5B or more,

as evaluated under the condition of HAST.

In the present disclosure, the HAST condition refers to a temperature of 100-150°C, humidity of 80-90% and a time of 80-100 hours, or a temperature of 110-140°C, humidity of 83-87% and a time of 90-100 hours.

The metallized glass substrate according to the present disclosure may show a plating uniformity of 75% or more, as determined through image analysis.

The metallized glass substrate according to the present disclosure may show a plating uniformity of 90% or more, as determined through image analysis.

The metallized glass substrate according to the present disclosure may show a plating coverage ratio of 80% or more.

The plating coverage ratio refers to the average value of T2/T1 ratio, T3/T1 ratio and T4/T1 ratio, after the cross-section of the metallized glass substrate is cut with focused ion beams (FIB) and the Cu thickness (T1) of the glass substrate surface (top surface) and the Cu thicknesses (T2, T3 and T4) depending on positions in the via-hole of the glass substrate are measured (see, FIG. 6).

More specifically, the plating coverage ratio may be calculated by using the following Formula 1 on the basis of the cross-section obtained by cutting the via-hole of the metallized glass substrate in a direction perpendicular to the top surface of the glass substrate with focused ion beams, after measuring the thickness (T1) of the metal layer at a position spaced apart from the via-hole by 100 μm on the top surface of the glass substrate, thickness (T2) of the metal layer at a position of the via-hole spaced apart from the top surface of the glass substrate by 25% of the thickness of the glass substrate, thickness (T3) of the metal layer at a position of the via-hole spaced apart from the top surface of the glass substrate by 50% of the thickness of the glass substrate, and the thickness (T4) of the metal layer at a position of the via-hole spaced apart from the top surface of the glass substrate by 75% of the thickness of the glass substrate, with the thickness of the glass substrate taken as 100%.

[Formula 1]

$$\text{Plating coverage ratio (\%)} = \left[\left(\frac{T2}{T1} \times 100\right) + \left(\frac{T3}{T1} \times 100\right) + \left(\frac{T4}{T1} \times 100\right)\right] \div 3$$

The metallized glass substrate according to the present disclosure may be used for semiconductor packaging. Specifically, the glass substrate according to the present disclosure may be used for packaging semiconductor chips/devices. More specifically, the term 'semiconductor packaging' generally refers to post-processing techniques for cutting processed wafers into chip shapes and packaging them, wherein glass substrates have been given attentions as next-generation semiconductor packaging materials functioning to link a semiconductor chip physically/electrically to a system. In order to allow such use as semiconductor packaging materials, some functions, including mechanical protection, electrical/mechanical linking and heat emission, are required. Particularly, in the case of a TGV hole substrate, a fine electrode path that helps electricity flow is contained in the glass substrate, and thus there is an advantage in that more chips and high-performance chips can be mounted.

The metallized glass substrate according to the present disclosure may be applied in the field of packaging requiring large area, such as artificial intelligence (AI), high-performance computer (HPC), data center, servers, networking, etc., and particularly to generative AI and HPC.

[Mode for Invention]

Hereinafter, the present disclosure is described in detail through examples. However, the examples according to the present disclosure may be changed into several different forms, and the scope of the present disclosure is not to be interpreted as being limited to the examples described below. The examples of the present specification are provided to describe the present disclosure more fully to those having ordinary knowledge in the art.

**<Example 1> Metallization of glass substrate**

Glass substrate 1 of the following Table 1 was used, and the glass substrate was plated through the following process.

[Table 1]

| | Thickness (T=1mm) | TGV hole diameter (mm) | Aspect ratio | Etching (via-hole formation) |
|---|---|---|---|---|
| Glass substrate 1 | 0.5T | 0.1 mm | 1:5 | O |
| Glass substrate 2 | 0.64T | 0.1 mm | 1:6.4 | O |

(continued)

| | Thickness (T=1mm) | TGV hole diameter (mm) | Aspect ratio | Etching (via-hole formation) |
|---|---|---|---|---|
| Glass substrate 3 | 0.84T | 0.1 mm | 1:8.4 | O |
| *Aspect ratio: ratio of diameter to thickness of TGV hole | | | | |

**(1) Pretreatment process**

A glass substrate (Glass substrate 1) was pretreated by dipping it in pretreatment composition A (monoethanolamine 5 wt%, N-methylpyrrolidone 15 wt%, ethyl diglycol 10 wt%, balance amount of water) at 50°C for 5 minutes, and then in pretreatment composition B (HCl 3 wt%, balance amount of water) at room temperature (25°C) for 2 minutes.

**(2) Glass substrate metallization-accelerating process (GCS-AP)**

The pretreated glass substrate was dipped in the following metallization-accelerating composition at room temperature (25°C) for 2 minutes, dipped in a Pd catalyst at 40°C for 5 minutes, and then dipped in a reducing agent at 30°C for 3 minutes to reduce the Pd catalyst.

**[Metallization-accelerating composition]**

A silane coupling agent (aminoethylaminopropyltrimethoxy silane, 0.5 wt%), a Pd binder (LCC-1 ($C_6H_{9-n}NO_6Li_n$, n = 2)), 1 wt%), a phase stabilizer (HCl, 0.3 wt%) and a solvent (water, balance amount) were mixed and agitated at room temperature for 2 hours to prepare a metallization-accelerating composition.

**(3) Glass substrate plating process**

The glass substrate was dipped in a plating composition containing Cu, a levelling agent and a stabilizer at 40°C for 30 minutes (electroless Cu plating) to form a Cu layer on the glass substrate.

**(4) Annealing process**

The glass substrate was dried by using an oven at 400°C under the atmosphere of $N_2$ for 60 minutes.

**<Example 2>**

A glass substrate was plated in the same manner as Example 1, except that glass substrate 2 of Table 1 was used instead of glass substrate 1 of Example 1.

**<Example 3>**

A glass substrate was plated in the same manner as Example 1, except that glass substrate 3 of Table 1 was used instead of glass substrate 1 of Example 1.

**<Comparative example 1>**

A glass substrate was plated in the same manner as Example 1, except that Cu seeds were formed on the surface of the glass substrate through a Cu sputtering process (dry process), while eliminating (1) pretreatment process and (2) glass substrate metallization-accelerating process (GCS-AP) of Example 1.

Specifically, Cu was introduced to a chamber by using a thin film deposition method to induce plasma so that an electric field might be formed, and gas decomposition was carried out to allow decomposed Cu atoms to form a thin film on the glass substrate, thereby forming Cu seeds.

**<Comparative example 2>**

A glass substrate was plated in the same manner as Comparative example 1, except that glass substrate 2 of Table 1 was used instead of glass substrate 1 of Comparative example 1.

**<Comparative example 3>**

A glass substrate was plated in the same manner as Comparative example 1, except that glass substrate 3 of Table 1 was used instead of glass substrate 1 of Comparative example 1.

**<Comparative example 4>**

A glass substrate was plated in the same manner as Example 1, except that Cu was deposited through a liquid phase deposition (LPD, metal oxide) process, while eliminating (1) pretreatment process and (2) glass substrate metallization-accelerating process of Example 1.

Specifically, Cu was sprayed to the surface of the glass substrate and deposited thereon while drying Cu.

**<Comparative example 5>**

A glass substrate was plated in the same manner as Comparative example 4, except that glass substrate 2 of Table 1 was used instead of glass substrate 1 of Comparative example 4.

**<Comparative example 6>**

A glass substrate was plated in the same manner as Comparative example 4, except that glass substrate 3 of Table 1 was used instead of glass substrate 1 of Comparative example 4.

**<Test examples>**

The plated glass substrates according to Examples and Comparative examples were evaluated in terms of their characteristics. The results are shown in the following Table 2. The characteristics as shown in Table 2 were evaluated by the following methods.

Electric conduction

Each plated glass substrate was checked for electric conduction by using a resistance meter. The results are shown as O (electric conduction) and X (short-circuit).

Plating uniformity

Each plated glass substrate was checked for plating uniformity through image analysis. The results are shown O (100% plating), □ (at least 75% plating), △ (at least 50% plating) and X (less than 50% plating).

Specifically, the plating uniformity was evaluated by the naked eyes with reference to the criteria of FIG. 5.

Adhesion at room temperature (cross-cut evaluation)

At room temperature, a lattice was formed on the plated glass substrate by using a cross-cutter (AT-CC3000 available from TOC Co./ASTM1), an adhesive tape (3M 8981 25 mm x 10 mm (7.6N), sp3020 available from TOC Co.) was adhered closely thereto and removed therefrom, and then the remaining lattice shape was evaluated. For the evaluation criteria, specification of ASTM D3359-08 was referenced.

HAST adhesion

The plated glass substrate was allowed to stand at a temperature of 130°C under a humidity of 85% for 96 hours, and the same evaluation as the above 'Adhesion at room temperature' was carried out.

Plating coverage ratio

The cross-section of the plated glass substrate was cut with focused ion beams (FIB), and then the thickness (T1) of the metal layer at a position spaced apart from the via-hole by 100 μm on the top surface of the glass substrate, thickness (T2) of the metal layer at a position of the via-hole spaced apart from the top surface of the glass substrate by 25% of the thickness (with the thickness of the glass substrate taken as 100%), thickness (T3) of the metal layer at a position of the via-hole spaced apart by 50% of the thickness, and the thickness (T4) of the metal layer at a position of the via-hole spaced

apart by 75% of the thickness were measured. Then, each of the ratio of T2/T1, ratio of T3/T1 and the ratio of T4/T1 was calculated, and the average value thereof was evaluated as a plating coverage ratio.

[Table 2]

| | Glass substrate | Metallization-accelerating process | Electric conduction | Plating uniformity | Room temperature adhesion | HAST adhesion | Plating coverage ratio |
|---|---|---|---|---|---|---|---|
| Example 1 | 1 | GCS-AP | ○ | O | 5B | 5B | 81% |
| Example 2 | 2 | | ○ | O | 5B | 5B | 86% |
| Example 3 | 3 | | ○ | ○ | 5B | 4B | 94% |
| Comparative Example 1 | 1 | Cu sputtering | ○ | ○ | 4B | 3B | 43% |
| ComparativeExample 2 | 2 | | X | □ | 4B | 3B | 39% |
| ComparativeExample 3 | 3 | | X | □ | 4B | 3B | 25% |
| ComparativeExample 4 | 1 | LPD | ○ | ○ | 4B | 3B | 53% |
| Comparativ e Example 5 | 2 | | ○ | ○ | 4B | 3B | 38% |
| Comparative Example 6 | 3 | | X | □ | 4B | 3B | 31% |
| * Comparative Examples 1 to 6: A conventional Cu sputtering process or LPD process is carried out instead of the metallization-accelerating process (GCS-AP) according to the present disclosure | | | | | | | |

As can be seen from the results of Table 2, the glass substrate plated through the metallization-accelerating process (GCS-AP) according to the present disclosure shows excellent plating uniformity, room temperature/HAST adhesion and plating coverage ratio, as compared to the group of Comparative Examples. Particularly, it can be seen from Examples 1 to 3 that the plating coverage ratio is increased even though the aspect ratio of the glass substrate is increased.

On the contrary, in the case of Comparative Examples 1 to 3 using a Cu sputtering process, it can be seen that the plating coverage ratio does not exceed 50% even under the condition of a low aspect ratio (1:5). It can be also seen that the plating coverage ratio is reduced as the aspect ratio is increased. Further, the glass substrates according to Comparative examples 1 to 3 shows poor results in terms of electric conduction and plating uniformity.

Similarly, in the case of Comparative Examples 4 to 6 using an LPD process, they show slightly improved performance as compared to Comparative Examples 1 to 3 using a Cu sputtering process, but it can be seen that their performance is merely at a level of 30-60% under the same aspect ratio condition, as compared to Examples 1 to 3.

As can be seen from the foregoing, when a glass substrate is plated through the metallization-accelerating process according to the present disclosure, even a glass substrate having a high aspect ratio allows plating at a high coverage ratio and can provide high adhesion strength not only at room temperature but also even under the condition of HAST.

## Claims

**1.** A glass substrate metallization process comprising: a glass substrate metallization-accelerating process; a glass substrate plating process; and an annealing process,

wherein the glass substrate metallization-accelerating process comprises a step of carrying out surface treatment of a glass substrate by using a glass substrate metallization-accelerating composition,
the glass substrate metallization-accelerating composition comprises a silane coupling agent and a Pd binder, and
the Pd binder is a metal ion-containing compound comprising a functional group capable of binding with the silane coupling agent.

2. The glass substrate metallization process according to claim 1, wherein the Pd binder is represented by the following Chemical Formula 1:

[Chemical Formula 1]

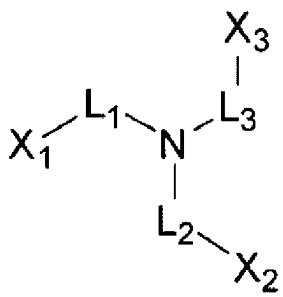

In Chemical Formula 1,

$L_1$ to $L_3$ are the same or different, and are each independently a C1-C5 alkylene group,
$X_1$ is $-NH_2$, -OH, -C(=O)OH or $-P(=O)(OH)_2$,
$X_2$ and $X_3$ are the same or different, and are each independently $-NH_2$, -OH, -C (=O) OH, -C (=O) $O^-M^+$, -P (=O) $(OH)_2$, -P(=O)(OH)($O^-M^+$) or -P(=O)$(O^-M^+)_2$,
M is Li or Na, and
at least one of $X_2$ and $X_3$ is -C (=O) $O^-M^+$, -P(=O)(OH) ($O^-M^+$) or -P(=O)$(O^-M^+)_2$.

3. The glass substrate metallization process according to claim 1, which further comprises a glass substrate pretreatment process.

4. The glass substrate metallization process according to claim 1, wherein the glass substrate metallization-accelerating process further comprises a step of applying a Pd catalyst.

5. The glass substrate metallization process according to claim 1, wherein the glass substrate metallization-accelerating process and the glass substrate plating process are wet processes.

6. The glass substrate metallization process according to claim 1, wherein the glass substrate has a thickness of 0.3-1.2 mm.

7. The glass substrate metallization process according to claim 1, wherein the glass substrate comprises a via-hole.

8. The glass substrate metallization process according to claim 7, wherein the via-hole has a diameter of 10-140 μm.

9. The glass substrate metallization process according to claim 7, wherein the glass substrate has an aspect ratio of 1:3 to 1:20.

10. A process for manufacturing a glass substrate comprising the glass substrate metallization process as defined in any one of claims 1 to 9.

11. The process for manufacturing a glass substrate according to claim 10, which further comprises a process for forming a via-hole in the glass substrate.

12. The process for manufacturing a glass substrate according to claim 11, wherein the process for forming a via-hole in the glass substrate comprises: a glass substrate laser modification process; and a glass substrate hole etching process.

13. A metallized glass substrate obtained by the process for manufacturing a glass substrate as defined in claim 10.

14. A metallized glass substrate comprising: a glass substrate; and a metal layer provided on the glass substrate,

wherein a metallization-accelerating layer is contained between the glass substrate and the metal layer, and the metallization-accelerating layer comprises a silane coupling agent, and a Pd binder containing a functional group bound with the silane coupling agent and a metal ion.

**15.** A metallized glass substrate comprising: a glass substrate having a via-hole; and a metal layer provided in the via-hole of the glass substrate,

wherein a metallization-accelerating layer is contained between the glass substrate and the metal layer, and the metallization-accelerating layer comprises a silane coupling agent, and a Pd binder containing a functional group bound with the silane coupling agent and a metal ion.

**16.** The metallized glass substrate according to claim 15, wherein the glass substrate has an aspect ratio of 1:5 to 1:20.

**17.** The metallized glass substrate according to claim 15, which has a plating coverage ratio of 80% or more, wherein the plating coverage ratio is calculated by using the following Formula 1 on the basis of the cross-section obtained by cutting the via-hole of the metallized glass substrate in a direction perpendicular to the top surface of the glass substrate with focused ion beams, after measuring the thickness (T1) of the metal layer at a position spaced apart from the via-hole by 100 μm on the top surface of the glass substrate, thickness (T2) of the metal layer at a position of the via-hole spaced apart from the top surface of the glass substrate by 25% of the thickness of the glass substrate, thickness (T3) of the metal layer at a position of the via-hole spaced apart from the top surface of the glass substrate by 50% of the thickness of the glass substrate, and the thickness (T4) of the metal layer at a position of the via-hole spaced apart from the top surface of the glass substrate by 75% of the thickness of the glass substrate, with the thickness of the glass substrate taken as 100%:

[Formula 1]

$$\text{Plating coverage ratio (\%)} = \left[\left(\frac{T2}{T1} \times 100\right) + \left(\frac{T3}{T1} \times 100\right) + \left(\frac{T4}{T1} \times 100\right)\right] \div 3$$

.

FIG. 1

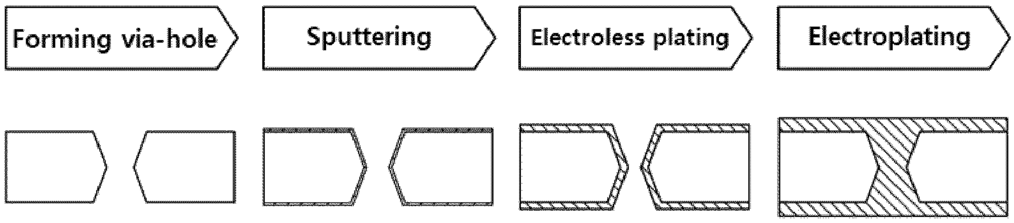


FIG. 2

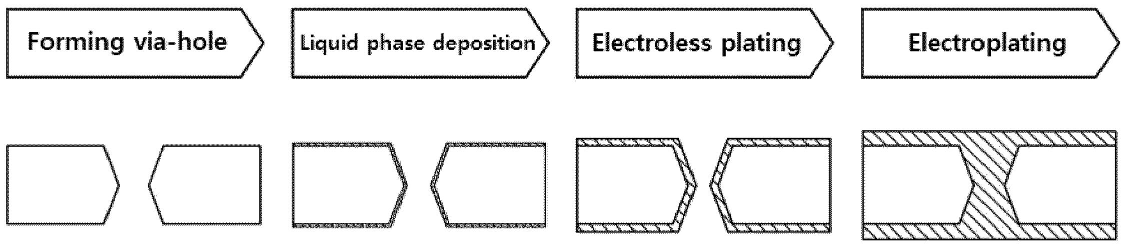


FIG. 3

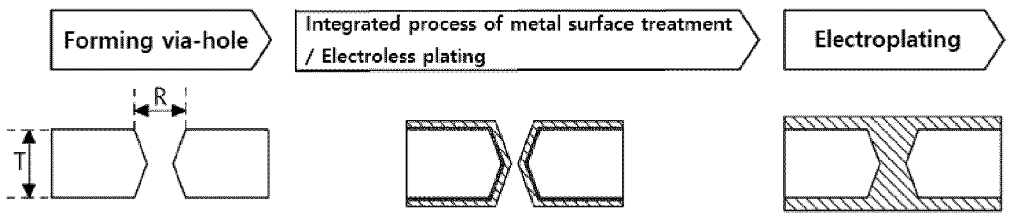


FIG. 4

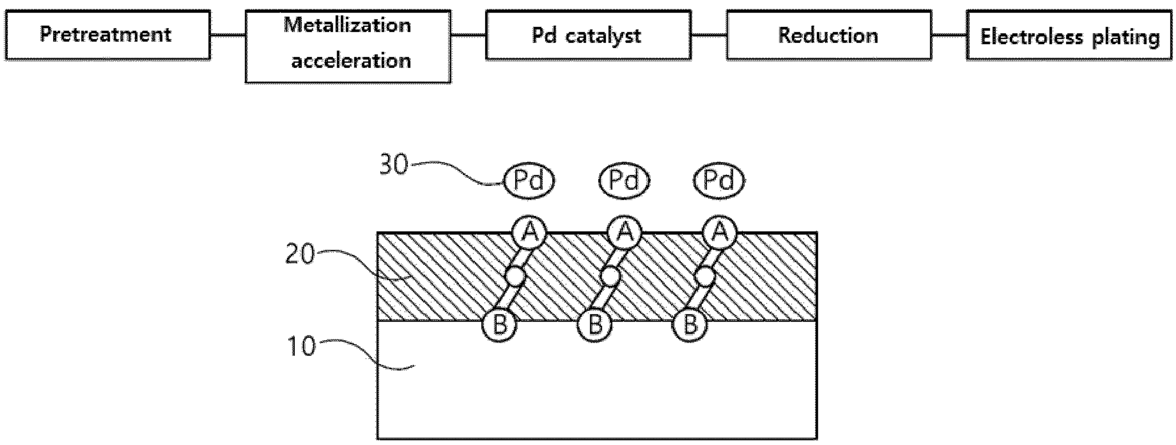

Fig. 5

○ (100%) □ (75%) △ (50%) X (<50%)

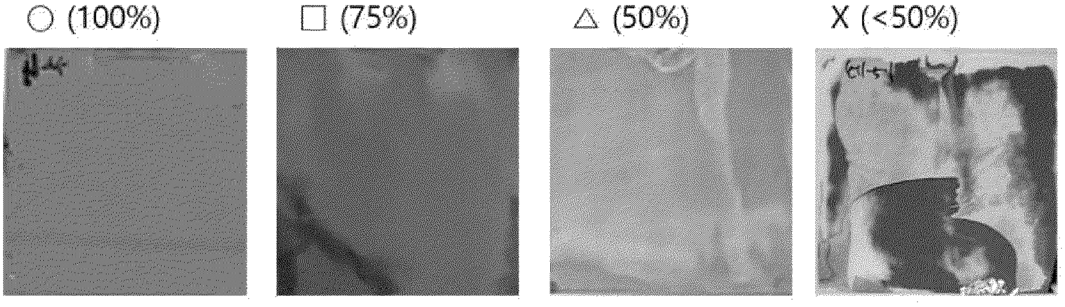

FIG. 6

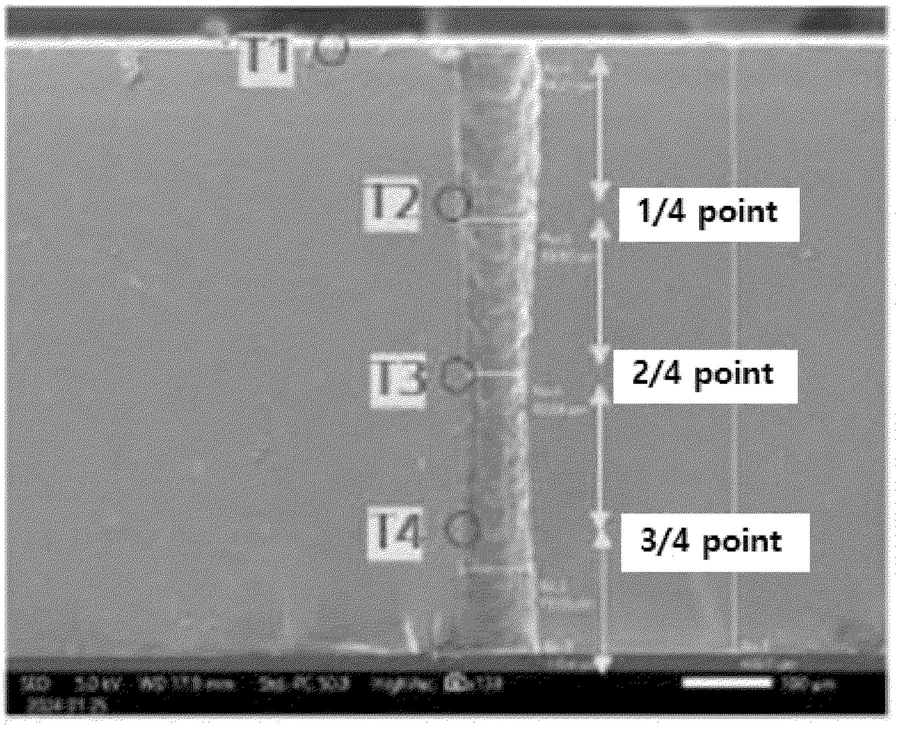

# INTERNATIONAL SEARCH REPORT

International application No.
**PCT/KR2025/001436**

## A. CLASSIFICATION OF SUBJECT MATTER

**H05K 3/38**(2006.01)i; **H05K 3/42**(2006.01)i; **H05K 3/00**(2006.01)i; **H05K 1/03**(2006.01)i; **C03C 17/36**(2006.01)i; **C03C 17/00**(2006.01)i; **C03C 15/00**(2006.01)i

According to International Patent Classification (IPC) or to both national classification and IPC

## B. FIELDS SEARCHED

Minimum documentation searched (classification system followed by classification symbols)

H05K 3/38(2006.01); B05D 1/00(2006.01); C03C 17/38(2006.01); C23C 18/18(2006.01); H01L 21/48(2006.01); H01L 23/14(2006.01); H05K 3/06(2006.01); H05K 3/18(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 유리 기판(glass substrate), 금속화(metalization), Pd 결합제(Pd binder), 실란 커플링제(silane coupling agent), 도금(plating)

## C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-063438 A (FUJI ELECTRIC DEVICE TECHNOLOGY CO., LTD.) 09 March 2006 (2006-03-09)<br>paragraphs [0018], [0021], [0025]-[0029]; figures 1, 2 | 1,3-5,10,13,14<br>2,6-9,11,12,15-17 |
| Y | KR 10-2023-0072477 A (CORNING INCORPORATED) 24 May 2023 (2023-05-24)<br>paragraphs [0019], [0022]-[0024], [0038], [0045]-[0048]; figures 1a, 2a, 2b | 2,6-9,11,12,15-17 |
| DY | KR 10-2010-0135603 A (SAMSUNG ELECTRO-MECHANICS CO., LTD.) 27 December 2010 (2010-12-27)<br>paragraphs [0019]-[0021]; figure 3 | 12 |
| A | CN 111987000 A (SHENZHEN INSTITUTES OF ADVANCED TECHNOLOGY, CHINESE ACADEMY OF SCIENCES) 24 November 2020 (2020-11-24)<br>claims 1-11 | 1-17 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **22 May 2025** | **22 May 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT

International application No.
**PCT/KR2025/001436**

**C. DOCUMENTS CONSIDERED TO BE RELEVANT**

| Category* | Citation of document, with indication, where appropriate, of the relevant passages | Relevant to claim No. |
|---|---|---|
| A | US 2004-0266173 A1 (ANDRY, P. S. et al.) 30 December 2004 (2004-12-30)<br>entire document | 1-17 |

Form PCT/ISA/210 (second sheet) (July 2022)

**INTERNATIONAL SEARCH REPORT**
**Information on patent family members**

International application No.
**PCT/KR2025/001436**

| Patent document cited in search report | Publication date (day/month/year) | Patent family member(s) | Publication date (day/month/year) |
|---|---|---|---|
| JP 2006-063438 A | 09 March 2006 | CN 1740388 A | 01 March 2006 |
| | | CN 1740388 C | 01 March 2006 |
| | | JP 4479528 B2 | 09 June 2010 |
| | | MY 147434 A | 14 December 2012 |
| | | SG 119318 A1 | 28 February 2006 |
| | | US 2006-0024431 A1 | 02 February 2006 |
| | | US 8039045 B2 | 18 October 2011 |
| KR 10-2023-0072477 A | 24 May 2023 | EP 4217325 A1 | 02 August 2023 |
| | | WO 2022-066407 A1 | 31 March 2022 |
| KR 10-2010-0135603 A | 27 December 2010 | None | |
| CN 111987000 A | 24 November 2020 | None | |
| US 2004-0266173 A1 | 30 December 2004 | JP 2003-218498 A | 31 July 2003 |
| | | JP 3827630 B2 | 27 September 2006 |
| | | US 2003-0068480 A1 | 10 April 2003 |
| | | US 6767828 B2 | 27 July 2004 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020240118561
- KR 1020240201651
- KR 1020100135603